# EUROPEAN PATENT APPLICATION

(11) **EP 1 316 522 A2**
(43) Date of publication of application: **04.06.2003**
(21) Application number: 02025864.6
(22) Date of filing: 19.11.2002
(51) Int. Cl.: B65H 67/00, H01L 21/00

(54) **Spool gripper and method of handling a spool using the same**

(30) Priority: 27.11.2001 KR 2001074394
(71) Applicant: W.C. Heraeus GmbH & Co. KG, 63450 Hanau (DE)
(72) Inventor: Back, Jung Woo, Yeunsu-go, Incheon, 406-130 (KR)
(74) Representative: Kühn, Hans-Christian

(57) **Abstract**

A spool gripper is coupled to any one of flanges provided at both sides of a spool wound with a semiconductor device bonding wire thereon. The spool gripper has an inner diameter portion for receiving a spool holder when the spool is fitted to the spool holder, a coupling portion coupled to the circumference of the flange while bearing a diameter larger than the inner diameter portion, and an outer diameter portion with a diameter larger than the coupling portion. The worker grips the outer diameter portion to handle the spool. The handling of the spool can be made without directly touching the spool. The wire bonding operation is made while the gripper being coupled to the flange. Therefore, it is not needed that the gripper should be decoupled from the flange to make the wire bonding operation. Accordingly, the durability of the gripper and the reliability in the spool holding can be maintained without deterioration while preventing separation of the spool from the gripper. Irrespective of the length of the spool holder or the presence of the spool fixation member, the spool handling unit can be used with any typed spool holder.

## Description

### BACKGROUND OF THE INVENTION

### (a) Field of the Invention

The present invention relates to a wire bonding assembly for processing a semiconductor chip package and, more particularly, to a spool gripper detachably fitted to a spool flange, and a method of handling a spool with the spool gripper which effectively prevents a bonding wire from being contaminated and damaged due to the carelessness of the worker.

### (b) Description of the Related Art

Generally, a wire bonding assembly is a device for electrically connecting a lead of a lead frame to a bonding pad of a semiconductor chip bearing an electrical characteristic by way of a conductive wire such as a high purity platinum Pt wire or an aluminum wire.

The wire bonding assembly is usually provided with a spool, a spool holder, a wire feed guider, a wire clamp, and a capillary. A conductive wire is wound on the spool, and the spool is fitted to the spool holder. The conductive wire is fused by way of the capillary and the torch bar, and welded to the bonding pad of the semiconductor chip and the lead.

In order to prevent the conductive wire from being separated from the spool while making the worker hold the spool and fit it to the spool holder, a flange is formed at both sides of the spool such that it is protruded from the spool by 4-5 mm in a radial manner. Various kinds of spool cases may be used to handle the spool. The handling of the spool may be storage and carriage thereof.

For instance, Japanese Utility Model Publication Number Sho 54-103747 discloses a spool case having a base with a protrusion onto which a cylindrical spool is inserted, and a cover coupled to the base to prevent an alien material such as dust from being introduced therein. The cover is provided with a depressed portion for receiving the spool in correspondence with the protrusion of the base.

With the above-structured spool case, the worker grips the flange of the spool by hand to bring out the spool from the spool case, and at that state, fits it to the spool holder.

However, as the spool flange is radially protruded from the spool at most by 4-5 mm, the wire wound on the spool becomes placed over the outermost circumference of the flange. Accordingly, with the handling of the spool, the fingers of the worker contact the surface of the conductive wire. In this case, the wire is contaminated or damaged, and this induces serious device failures during the wire bonding process.

Korean Utility Model Publication No. 97-52837 discloses a spool having a one-sided flange with a first diameter, and an opposite-sided flange with a second diameter. The second diameter is established to be significantly larger than the first diameter. The worker grips the large diameter flange to fit the spool to the spool holder.

Japanese Patent Publication Laid-open No. 2000-012599 discloses a bonding wire spool case with a base. The base has an interfacial coupling member externally fitted around the spool flange to hold the spool, and a knob externally protruded to receive a spool holder. The base is established to be capable of being elastically transformed. In order to decouple the spool from the base, the worker grips the knob, and elastically transforms the base.

However, such a spool with a large diameter flange involves several problems.

The spool used in the wire bonding assembly may be differentiated in structure per the respective semiconductor chip package manufacturing companies. For instance, it is possible that the A company uses a spool where only the one-sided flange is formed with a large diameter, whereas the B company uses a spool where all of the both-sided flanges are formed with a small diameter (4-5 mm). With this situation, in order to supply the correct spools to both of the A company and the B company, the spool manufacturing company should make a facility for producing the former-typed flange and a facility for producing the latter-typed flange in a separate manner. This inevitably causes increased production cost.

Meanwhile, with the spool case disclosed in Japanese Patent Publication Laid-open No. 2000-012599, the base with the interfacial coupling member is formed with a material capable of being elastically transformed such that the spool can be decoupled from the base by way of the interfacial coupling member.

In case the base repeatedly suffers the elastic transformation in coupling or decoupling the spool, stress is made at a predetermined region of the base due to the elastic transformation. Consequently, the base is stress-damaged while being deteriorated in its durability.

The interfacial coupling member, which is connected to the base in a body to substantially hold the spool, is formed with an elastic plastic material. With the repeated uses, the interfacial coupling member becomes worn out or blunt, and this deteriorates reliability in the spool holding operation.

Furthermore, with the handling of the spool, the worker picks out the cover from the base, and grips the base to fit the spool to the spool holder of the bonding assembly. At this time, the worker may inattentively grip both sides of the base. In this case, the spool holding operation by way of the interfacial coupling member is released, and as a result, the spool is decoupled from the base. Consequently, the bonding wire is contaminated, and damaged.

Furthermore, in case the spool holder is longer than the sum in length of the spool and the knob, the spool is incompletely fitted to the spool holder so that the spool coupling and decoupling operation by way of the base cannot be easily made. In case the spool holder has a holder knob at its end portion, the holder knob is internally caught by the knob of the base so that the spool coupling and decoupling operation using the base becomes impossible while delimiting the usable range of the spool case.

### SUMMARY OF THE INVENTION

It is an object of the present invention to provide a gripper capable of being coupled to or decoupled from a spool flange, and a unit and a method of handling a spool with the gripper.

This and other objects may be achieved by a spool gripper and a spool handling unit with the following features.

A spool gripper is coupled to any one of flanges provided at both sides of a spool wound with a semiconductor device bonding wire thereon. The spool gripper has an inner diameter portion for receiving a spool holder when the spool is fitted to the spool holder, a coupling portion coupled to the circumference of the flange while bearing a diameter larger than the inner diameter portion, and an outer diameter portion with a diameter larger than the coupling portion.

With the spool gripper, the facility cost is not increased while satisfying the requirements of the package manufacturing company. In case spools are delivered to the package manufacturing company where the desired spool has a large diameter flange, the delivery is made while the gripper being coupled to the flange of the spool. Therefore, an additional facility for making a large diameter flange is not needed.

Furthermore, the distance between the bonding wire wound on the spool and the outer diameter portion of the gripper becomes enlarged to be greater than that related to the conventional small diameter flange. Therefore, the handling of the spool can be made without directly touching the spool. The coupling state of the gripper to the spool is not released unless the gripper is intentionally separated from the flange. As the wire bonding operation is made while the gripper being coupled to the flange, it is not needed that the gripper should be decoupled from the flange to make the wire bonding operation. Accordingly, the durability of the gripper and the reliability in the spool holding can be maintained without deterioration while preventing separation of the spool from the gripper.

At least two coupling protrusions are formed at the coupling portion while being inwardly protruded in a radial manner. The coupling protrusion may be positioned at the periphery of the coupling portion, or at the center thereof.

The coupling protrusion should be formed at the same height as the thickness of the flange to fit the gripper to the flange. With the placing of the coupling protrusion at the middle of the coupling portion, the thickness of the outer diameter portion is enlarged by a predetermined degree. Accordingly, when the worker grips the gripper, the fingers of the worker do not touch the conductive wire W.

A plurality of prominent portions are formed at the gripper to make a space for receiving the end of the conductive wire W fastened to the outer surface of the spool flange by way of a tape. When the gripper is coupled to the spool flange, the end of the conductive wire W is placed within the space, and hence, possible damage thereof can be prevented.

The gripper may be formed with a metallic plate ring, or a plastic plate ring. In the latter case, it is preferable that cutting planes are formed at the gripper. When the worker grips the gripper, the gripper can be transformed while compressing the inner diameter portion, due to the presence of the cutting planes. Accordingly, with the gripping of the gripper, the spool can be securely coupled to the gripper without separation.

A spool handling unit with the gripper includes a spool case for storing the spool. The spool case has a base for mounting the spool, and a cover coupled to the base to prevent alien materials such as dust from being introduced. The base has a bottom portion, a sidewall protruded from the bottom portion, and a protrusion formed at the bottom portion internal to the sidewall while being inserted into the inner diameter portion of the spool. The cover has a protrusion inserted into the inner diameter portion of the spool fitted to the base to make the central axis of the spool be kept to be in the horizontal direction.

The central axis of the spool is placed at a horizontal plane in a stable manner. Accordingly, the bonding wire W wound on the spool deals well with its own load, vibration in its movement and other impacts over its entire length while effectively preventing the unintended winding or releasing thereof.

A stopper may be formed at the cover to make the central axis of the spool be kept to be in the horizontal direction.

### BRIEF DESCRIPTION OF THE DRAWINGS

A more complete appreciation of the invention, and many of the attendant advantages thereof, will be readily apparent as the same becomes better understood by reference to the following detailed description when considered in conjunction with the accompanying drawings in which like reference symbols indicate the same or the similar components, wherein:
Fig. 1 is a perspective view of a spool gripper according to a preferred embodiment of the present invention;
Fig. 2 is a cross sectional view of the spool gripper taken along the A-A line of Fig. 1;
Fig. 3 is a cross sectional view of the spool gripper taken along the A-A line of Fig. 1, illustrating a variation thereof;
Fig. 4 is a perspective view of a spool gripper according to another preferred embodiment of the present invention;
Fig. 5 is an exploded perspective view of a spool handling unit with the spool gripper; and
Fig. 6 illustrates the process of handing a spool with the spool gripper.

### DETAILED DESCRIPTION OF THE PREFERRED EMBODIMENTS

Preferred embodiments of this invention will be explained with reference to the accompanying drawings.

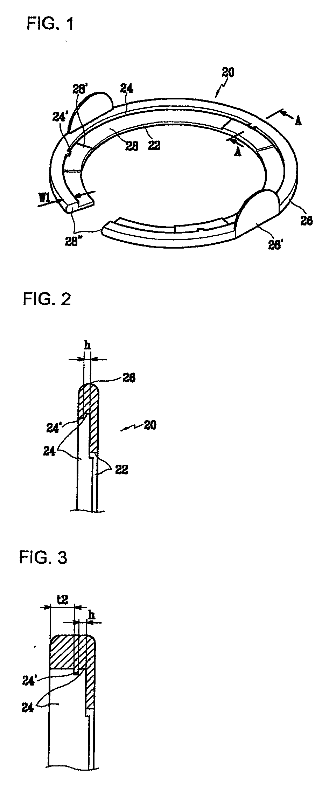

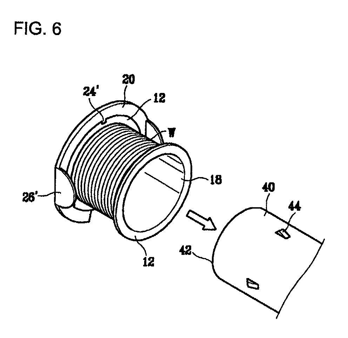

Fig. 1 is a perspective view of a spool gripper according to a preferred embodiment of the present invention, and Fig. 2 is a cross sectional view of the spool gripper taken along the A-A line of Fig. 1. Fig. 5 is an exploded perspective view of a spool handling unit with the spool gripper.

The spool 10, well known in the art, is wound with a bonding wire W thereon. As shown in the drawings, the spool 10 is formed with a cylinder portion (not shown) for winding the bonding wire W thereon, and a pair of small diameter flanges 12 provided at both ends of the cylinder portion. A notch 14 is formed at the one-sided small diameter flange 12 to hold the end portion of the bonding wire W. The end of the bonding wire W passed the notch 14 is fastened to the outer surface of the flange 12 by way of a tape 16.

A spool gripper 20 is coupled to one of the flanges 12 such that it can be decoupled from the flange 12. The spool gripper 20 is formed with a plastic material while bearing a plate ring shape. The spool gripper 20 has an inner diameter portion 22 bearing a diameter identical to or lager than the inner diameter portion 18 of the spool 10, a coupling portion 24 coupled to the circumference of the flange 12 while bearing a diameter larger than the inner diameter portion 22, and an outer diameter portion 26 bearing a diameter lager than the coupling portion 24. With the handling of the spool 10, the worker grips the outer diameter portion 26 of the spool gripper 20.

At least two coupling protrusions 24', preferably three coupling protrusions 24' are equidistantly formed at the coupling portion 24 to hold the flange 12 while being inwardly protruded in a radial manner. The coupling protrusions 24' are positioned at the periphery of the coupling portion 24 while bearing a height corresponding to the thickness of the flange 12.

A plurality of prominent portions 28' are formed at the gripper 20 to make a space 28 for receiving the end of the conductive wire W fastened to the outer surface of the spool flange 12 by way of a tape. When the gripper 20 is coupled to the spool flange 12, the end of the conductive wire W is placed within the space 28, and hence, possible damage thereof can be prevented.

Meanwhile, the gripper 20 bears cutting planes 28". When the worker grips the gripper 20, the gripper 20 can be transformed while compressing the inner diameter portion 22, due to the presence of the cutting planes 28".

Accordingly, with the gripping of the gripper 20, the spool 10 can be securely coupled to the gripper 20 without separation.

A pair of knobs 26' are formed at the outer diameter portion 26 while facing each other. It is preferable that the knobs 26 should be spaced apart from the cutting planes 28" by the same distance.

With the knobs 26', the contamination and damages of the conductive wire can be further effectively prevented.

When the gripper 20 is coupled to the spool flange 12, the distance of the bonding wire wound on the spool 10 to the outer diameter portion 26 of the gripper 20 becomes enlarged by a predetermined dimension W1, compared to the small diameter flange 12. Furthermore, the handling of the spool 10 can be made without directly touching the spool 10 due to the knobs 26'. In this way, the contamination and damage of the conductive wire W due to the touching of the worker's fingers thereon can be prevented. Furthermore, the coupling state of the gripper 20 is not released unless the gripper 20 is intentionally decoupled from the flange 12. The insertion of the spool holder 40 is made through the inner diameter portion 22 of the gripper 20 so that the wire bonding operation can be performed with the coupling of the gripper 20 to the flange 12. Consequently, it is not needed to decouple the gripper 20 from the flange 12. In this way, the durability of the gripper 20 is enhanced. Particularly, the abrasion of the coupling protrusions 24' are prohibited as much as possible while securing the reliability of the spool holding.

Fig. 3 illustrates a variation of the gripper where the coupling protrusion 24' is formed at the center of the coupling portion 24. Other components and structures of the gripper are the same as those of the gripper shown in Figs. 1 and 2.

The coupling protrusion 24' should be formed at the same height h as the thickness t of the flange 12 to fit the gripper 20 to the flange 12. With the placing of the coupling protrusion 24' at the middle of the coupling portion 24, the thickness of the outer diameter portion 26 is enlarged by a predetermined degree t2. Accordingly, when the worker grips the gripper 20, the fingers of the worker do not touch the conductive wire W.

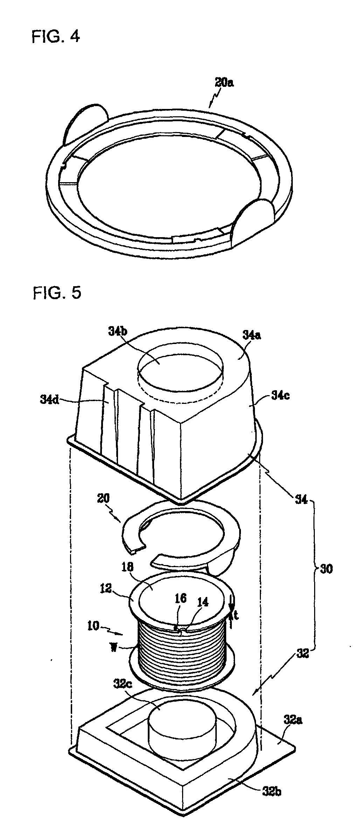

Fig. 4 is a perspective view of a spool gripper 20a according to another preferred embodiment of the present invention. The gripper is formed with a metallic material. As the metallic material-based gripper cannot be inwardly transformed in a radial manner, it is formed with a plate ring having no cutting plane (as indicated by 28" in Fig. 1).

A unit of handling a spool and a method of handling the spool will be now explained with reference to Figs. 5 and 6.

The spool handling unit with the above-structured gripper 20 has a spool case 30 for storing and carrying the spool 10.

The spool case 30 is formed with synthetic resin based on acryl, polyolefin, or styrene. The spool case 30 has a base 32, and a cover 34 coupled to the base 32.

The base 32 is formed with a bottom portion 32a, a sidewall 32b protruded from the bottom portion 32a, and a protrusion 32c protruded from the bottom portion 32a internal to the sidewall 32b. The inner diameter portion 18 of the spool 10 is inserted onto the protrusion 32c.

The cover 34 is fitted to the outer surface of the sidewall 32b from the top of the base 32 to prevent the bonding wire W of the spool 10 from being contaminated due to an alien material such as a dust. The cover 34 has a protrusion 34b inserted into the inner diameter portion 18 of the spool 10 to make the central axis of the spool 10 be maintained to be in the horizontal direction, corresponding to the protrusion 32c of the base 32.

The protrusion 32c of the base 32 and the protrusion 34b of the cover 34 are formed with a circular plane shape such that the diameter thereof is identical to or smaller than the inner diameter of the spool 10. The length of the protrusions 32c and 34b is established to be 30% of the length of the spool 10.

The sidewall 34c bent from the top portion 34a of the cover 34 is formed with a cone shape, which is tapered toward the top portion 34a. A stopper 34d is formed at the sidewall 34c of the cover 34 to make the central axis of the spool 10 be maintained to be in the horizontal direction.

The spool case may be differently structured with suitable modifications.

With the use of the spool handling unit, the spool 10 wound with the bonding wire W thereon is fitted to the bottom 32a of the base 32 in an erect posture such that the gripper 20 is positioned at the top side (the cover side). The cover 34 is coupled to the base 32 from the top side of the base 32 such that the protrusion 34b of the cover 34 is inserted into the inner diameter portion 18 of the spool 10.

In this state, the spool case 30 is put on a table (not shown) such that the stopper 34d is directed toward the bottom.

As the central axis of the spool 10 is maintained to be in the horizontal direction, the bonding wire W wound on the spool 10 uniformly distributes its own weight, its vibration in the movement or handling thereof and other impacts over its entire length so that the undesirable winding or releasing of the wire can be effectively prohibited, and the rolling of the spool case 30 can be avoided.

In case the spool 10 is fitted to the spool holder 40 of the wire bonding assembly (not shown), the worker grips the base 32 by one hand and, in that state, grips the sidewall of the cover 34 by the other hand. Thereafter, the cover 34 is lifted upward to thereby decouple the cover 34 from the base 32.

With the gripping of the knob 26' of the gripper 20, the spool 10 is fitted to the spool holder 40 while being moved in the arrow direction. At this time, the end portion 42 of the spool holder 40 passes the inner diameter portion of the spool 10 and the gripper 20. In this way, irrespective of the length of the spool holder 40, the coupling or decoupling of the spool 10 can be made. Furthermore, in the case of the spool holder with a holder knob at its end portion 42, the coupling or decoupling of the spool 10 can be made irrespective of the presence of the knob 26' of the gripper 20.

In this way, the spool 10 is fixedly fitted to the spool holder 40 by way of a spool fixation member 44 and/or a holder knob (not shown). In the wire bonding operation, the gripper 20 is constantly fitted to the flange 12 of the spool 10.

When the spool 10 is separated from the spool holder 40 to exchange it, the knob 26' of the gripper 20 fitted to the flange 12 of the spool 10 is gripped, and the spool 10 is drawn in the direction opposite to the arrow direction, thereby completing the separation of the spool 10.

As with the conventional spool having a large diameter flange, in the inventive structure, the distance between the bonding wire wound on the spool and the outer diameter portion of the gripper becomes enlarged to be greater than that related to the conventional small diameter flange.

Therefore, the handling of the spool can be made without directly touching the spool. Furthermore, as a knob is formed at the outer diameter portion of the gripper, the possible contamination and damages of the conductive wire due to the finger touching can be prevented.

Furthermore, the coupling state of the gripper to the spool is not released unless the gripper is intentionally separated from the flange. As the wire bonding operation is made while the gripper being coupled to the flange, it is not needed that the gripper should be decoupled from the flange to make the wire bonding operation. Accordingly, the durability of the gripper and the reliability in the spool holding can be maintained without deterioration while preventing separation of the spool from the gripper.

As the gripper involves a space for receiving the end portion of the conductive wire, the possible damage to the conductive wire due to the gripper can be prevented.

As the usual spool or spool case is used without any modification, the production cost can be reduced. The central axis of the spool is placed at a horizontal plane in a stable manner. Accordingly, the bonding wire W wound on the spool deals well with its own load, vibration in its movement and other impacts over its entire length while effectively preventing the unintended winding or releasing thereof.

With the inventive gripper, the facility cost is not increased while satisfying the requirements of the package manufacturing company. In case spools are delivered to the package manufacturing company where the desired spool has a large diameter flange, the delivery is made while the gripper being coupled to the flange of the spool. Therefore, an additional facility for making a large diameter flange is not needed.

With the inventive spool handling unit, the spool is fitted to the spool holder using a gripper. Therefore, irrespective of the length of the spool holder or the presence of the spool fixation member, the spool handling unit can be used with any typed spool holder. As the spool handling process is similar to that related to the conventional spool, any confusion is not made to the worker.

While the present invention has been described in detail with reference to the preferred embodiments, those skilled in the art will appreciate that various modifications and substitutions can be made thereto without departing from the spirit and scope of the present invention as set forth in the appended claims.

## Claims

1. A spool gripper coupled to any one of flanges provided at both sides of a spool wound with a semiconductor device bonding wire thereon, the spool gripper comprising:
an inner diameter portion for receiving a spool holder when the spool is fitted to the spool holder;
a coupling portion coupled to the circumference of the flange while bearing a diameter larger than the inner diameter portion; and
an outer diameter portion with a diameter larger than the coupling portion, the worker gripping the outer diameter portion to handle the spool.

2. The spool gripper of claim 1 wherein at least two coupling protrusions are formed at the coupling portion while being inwardly protruded in a radial manner.

3. The spool gripper of claim 2 wherein the coupling protrusion is positioned at the periphery of the coupling portion.

4. The spool gripper of claim 2 wherein the coupling protrusion is positioned at the center of the coupling portion.

5. The spool gripper of claim 2 further comprising a plurality of prominent portions for forming a space for receiving the end portion of the conductive wire fitted to the flange.

6. The spool gripper of claim 1 wherein a pair of knobs are formed at the outer diameter portion while facing each other.

7. The spool gripper of claim 1 further comprising cutting planes for making transformation of the inner diameter portion while being compressed.

8. The spool gripper of claim 1 further comprising a plurality of prominent portions for forming a space for receiving the end portion of the conductive wire fitted to the flange.

9. A spool handling unit comprising the gripper of any one of claims 1 to 8, and a spool case for storing the spool, the spool case having a base for mounting the spool, and a cover coupled to the base to prevent alien materials such as dust from being introduced.

10. The spool handling unit of claim 9 wherein the base has a bottom portion, a sidewall protruded from the bottom portion, and a protrusion formed at the bottom portion internal to the sidewall while being inserted into the inner diameter portion of the spool, and the cover has a protrusion inserted into the inner diameter portion of the spool fitted to the base to make the central axis of the spool be kept to be in the horizontal direction, and a stopper for making the central axis of the spool be kept to be in the horizontal direction.

11. A method of handling a spool using the spool handling unit of claim 10, the method comprising the steps of mounting the spool to the spool case, storing and carrying the spool such that the central axis of the spool is maintained to be in the horizontal direction, gripping the gripper coupled to the spool, fitting the spool to the spool holder, and performing a wiring bonding operation while the gripper being coupled to the spool.
